# EUROPEAN PATENT SPECIFICATION

(11) **EP 4 380 049 B1**
(45) Date of publication and mention of the grant of the patent: **01.07.2026**
(21) Application number: 23020533.8
(22) Date of filing: 30.11.2023
(51) Int. Cl.: H03G 7/00, H03G 3/30, H04R 29/00, H04R 27/00

(54) **A SIGNAL PROCESSING METHOD**
SIGNALVERARBEITUNGSVERFAHREN
PROCÉDÉ DE TRAITEMENT DE SIGNAL

(30) Priority: 02.12.2022 FI 20227155
(43) Date of publication of application: 05.06.2024
(73) Proprietor: Oeksound Oy, 00101 Helsinki (FI)
(72) Inventor: Keskinen, Olli, 00250 Helsinki (FI)
(74) Representative: Levlin, Jan Markus

(56) References cited:
- WO-A1-2021/233809
- JP-A- S61 121 625
- US-A1- 2007 078 645
- US-A1- 2010 142 727
- VICKERS ET AL: "The Non-Flat and Continually Changing Frequency Response of Multiband Compressors", AES CONVENTION 129; NOVEMBER 2010, AES, 60 EAST 42ND STREET, ROOM 2520 NEW YORK 10165-2520, USA, 4 November 2010 (2010-11-04), XP040567181

## Description

### 1. Field of the invention

This invention is related to signal processing of music. The invention specifically concerns removal of unwanted artifacts from a music signal.

### 2. Description of prior art

Music signals often include unwanted artifacts, especially during recording sessions or live sessions. The room along with the equipment and its positioning may cause various resonances, and unwanted strengthening of some frequencies and a skew in the tonal balance. For recorded music, these can be removed in post processing after the recording session either manually or using automated tools. This correction work is typically difficult and highly intensive if done manually. In live sound reinforcement and broadcasting situations there is the additional requirement of short response time.

The need for digital sound processing has increased markedly in the last decades. Sound processing is an essential part of today's sound aesthetics, and sound processing has become an inseparable part of how sound is expected to be heard. A live music production is nowadays expected to approach the same as sonic quality as the recorded sound, and to achieve this the sound must be tightly controlled both in dynamics and tone. On the other hand, the live sound and broadcast engineers expect to use similar tools as those used in the recording industry and studio work.

Sound amplification in live events has certain demanding requirements. The sound system must have low latency, with the total latency being preferably below 10 ms. This is the preferable maximum delay over the whole audio chain, including wireless microphones, analog to digital converters, signal processing devices, digital to analog converters, any processing within the sound reproduction systems, and any other devices handling the audio signals.

Large productions have strong scheduling pressures, and personnel responsible for sound quality typically have only a very limited time available for correcting the sound quality. In addition, problems often arise during the actual live event as conditions change in the acoustics of the performing space, or if any sound technology or audio reproduction devices are changed, whereby all problems cannot be corrected in preproduction before the show.

Microphones often cause difficulties as the chosen sizes, placements and directional patterns of the microphones may affect the sound quality negatively. Microphones often need to be placed closer to the sound source due to mic bleed and practicality than would be optimal considering the quality of sound. Close to an instrument or the mouth of a singer unnatural resonances and tonal imbalances are enhanced due to unnevenness in the directional pattern of the sound source and in turn by the directional pattern of the microphone. These unevennesses typically vary with the played or sung note, as they are a direct result from the acoustical properties of the sound sources. In order to obtain a good quality show even when microphone arrangements are suboptimal, resulting resonances need to be attenuated dynamically in the sound signal.

Many artifacts start quickly and suddenly, whereby it is important for the quality of the end result that the attenuation process can react fast to new resonances. Conditions in the acoustical environment often change e.g. due to movement of musicians and other disturbances may happen in live situations, easily causing different artifacts that can arise quickly. Consequently, any processes attenuating and removing artifacts need to act with equal speed.

Digital mixer systems employ high sampling frequencies with the typical sampling rate starting from 44.1 kHz and ranging all the way up to 192 kHz, with higher rates being increasingly popular. High sampling frequencies are often desired, since they allow nonlinear processing of the sound without oversampling required at lower sampling frequencies, which simplifies the sound processing architecture. Using higher sampling rates places more demand on the underlying digital signal processors, however, which in turn increase the cost.

Further, the fundamental frequencies of typical instruments are in the range of 80 Hz to 260 Hz, and those of bass instruments even lower. Processing of low-frequency artifacts require use of larger FFT sizes than are needed for mid- and highfrequency ranges. Larger FFT sizes are more resource consuming to calculate, and in general, all analysis operations require more computing power when analysis is performed with larger vector sizes.

Uneven directional patterns at the fundamental frequency and a few of the first harmonics are especially problematic, as low frequencies present a high computational load. Analysis and reliable processing of a low frequency signal with fast fourier transforms (FFT) requires high resolution: at sampling frequency of 44.1 kHz reliable processing of a 80 Hz signal could be argued to require the use of a large FFT with at least 2048 bins for convolution operations. Calculation of FFTs is a resource intensive operation, and calculation of large FFTs even more so. Further, the need for low latency and the rapidly changing corrective needs require calculation of such a large FFT even 6000 times per second merely for implementing a single convolution step with dynamically adapting filter response. These factors combine to require a high processing power.

A modern live production typically requires many sound channels, whereby the cost per channel is an essential question for budgeting the show. However, powerful DSP (digital signal processing) processors are expensive, whereby the simple solution of increasing the computing power of the DSP equipment is not feasible in many situations. The total cost of the sound system needs to be kept at reasonable levels, whereby reducing the need for high signal processing power is important. New processing methods that reduce the computing power requirements are needed.

The article VICKERS ET AL: "The Non-Flat and Continually Changing Frequency Response of Multiband Compressors", AES CONVENTION 129; NOVEMBER 2010, AES, 60 EAST 42ND STREET, ROOM 2520 NEW YORK 10165-2520, USA, 4 November 2010 (2010-11-04), XP040567181, describes non-flat and continually changing frequency response of multiband compressors.

Patent application US 2007/078645 discloses filterbank-based processing of speech signals.

Patent application US 2010/142727 discloses various sound processing methods and apparatus.

### SUMMARY OF THE INVENTION

The invention is directed to the method, sound processing device, and computer-readable storage media described in the independent claims 1, 5 and 7.

The invention solves the problems of prior art by providing a method for attenuating resonances in a sound signal, which method uses sub-sampling of at least one sub-band of the original signal to save computing resources. As a coarse overview description, the method comprises at least steps in which
an incoming signal block is filtered into at least two different frequency sub-band signals,
at least one of the sub-band signals is subsampled,
a resonance analysis step is performed for each sub-band signal, said step resulting in a filter response,
a sub-band block from each sub-band is convoluted with the corresponding filter response to produce a filtered sub-band block,
for each subsampled sub-band, the filtered sub-band block is upsampled,
the upsampled sub-band blocks of subsampled sub-bands and filtered sub-band blocks of any non-subsampled sub-bands are combined to form a result signal block.

This method saves computing resources by performing analysis based on subsampled sub-band blocks.

These and other features of the present invention will be described in more detail below in the detailed description of the invention and in conjunction with the following figures.

### BRIEF DESCRIPTION OF THE DRAWINGS

Various embodiments of the invention will be described in detail below, by way of example only, with reference to the accompanying drawings, of which
Figure 1 describes how incoming signal blocks are processed,
Figure 2 describes the resonance analysis step in more detail, and
Figure 3 illustrates a device according to an embodiment of the invention.

### DETAILED DESCRIPTION OF CERTAIN EMBODIMENTS

The following embodiments are exemplary.

In the following, features of the invention will be described with a simple example of a sound processing method with which various embodiments of the invention may be implemented. Only elements relevant for illustrating the embodiments are described in detail. Details that are generally known to a person skilled in the art may not be specifically described herein.

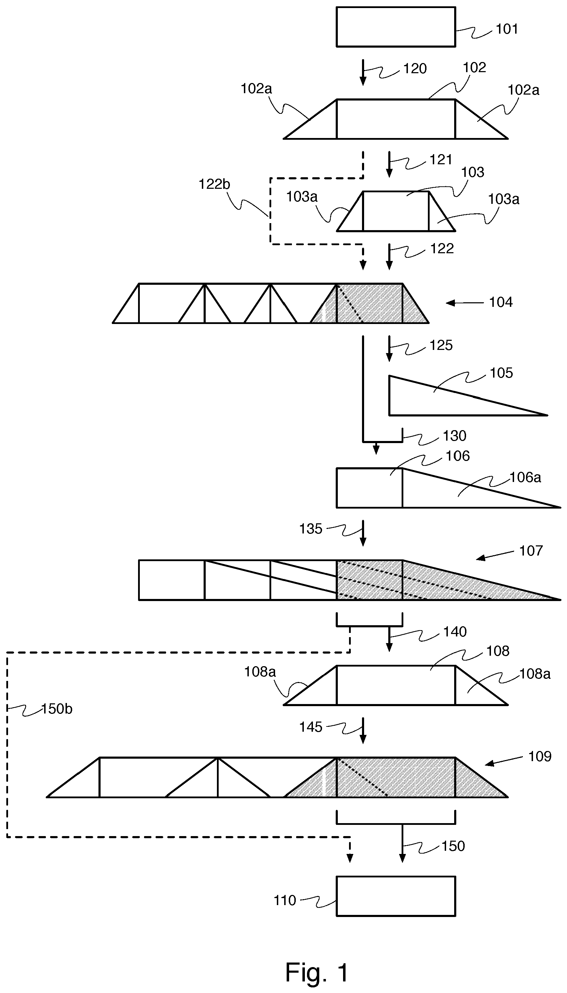

Figure 1 illustrates processing of signals according to an embodiment of the invention. Figure 1 shows how signal blocks are processed, transformed, added into various buffers, and extracted from various buffers for the next processing steps. Figure 1 illustrates processing of a single incoming signal block, and particularly processing of such a sub-band of the incoming signal, which sub-band is processed in subsampled form.

Figure 1 shows an incoming signal block 101. In figure 1, the width of the block represents the number of samples in the block, while the height of the block represents maximum amplitude of the signal sample. The number of samples in an incoming signal block is dependent of the implementation, and is in typical digital signal processing systems 8 samples or more. The invention is not limited to any specific block size or block size range. The number of bits in a sample depends on the implementation. At the time of writing of this specification, typical sample sizes used in digital signal processing are 8, 16, 24, or 32 bits. The invention can be used with any of these sample sizes. The invention is not limited to any specific size or way of representation of a signal sample.

First, the incoming signal block 101 is divided 120 into at least two sub-band signal blocks 102 corresponding to different frequency bands. For clarity, figure 1 shows only one of the sub-band blocks 102. The division can be performed for example by filtering, i.e. by using low pass, high pass, and/or bandpass filtering or various combinations of them as is well known by a man skilled in the art. Such filtering operations can also be performed in the frequency domain using fourier transform, for example by taking a fourier transform of the signal, multiplying the resulting spectrum by a desired filter spectrum, and taking the inverse fourier transform of that result. Depending on the type of filter used, filtering may cause smearing on one or both sides of the resulting filtered block, as is well known by a man skilled in the art. This smearing effect is illustrated by the features 102a in figure 1, which represent signal content that is smeared by the filtering producing a number of samples with some signal content on either side of the block 102.

Next, at least one of the sub-band signals 102 - including the smeared out features 102a - are subsampled 121 to form a subsampled sub-band signal 103, 103a. The subsampling factor can in different embodiments of the invention be 2, 4, 8 or more. The subsampling factor can also be different for different sub-bands. In subsampling with factor n, every n:th sample is retained, while the rest of samples are discarded.

Next, the subsampled signal 103, 103a is added 122 to a buffer 104. The addition performed in such a way that that the block 103 is to be the first block in the buffer 104, while any smearing features of a previously added block are summed with corresponding samples in block 103, and the samples comprising the smearing features 103a of block 103 are summed with corresponding samples in the buffer, in order to retain signal information comprised in the smearing features.

Next, a resonance analysis step is performed 125 based on at least the newest block in the buffer 104. In a further embodiment, resonance analysis is based on two or more of the most recent blocks in the buffer 104. Using more than one of the most recent blocks has the advantage that the resonance analysis step then has more past signal context available.

The resonance analysis step, which is described in more detail later in this specification, results in a filter response 105. The filter response is convolved 130 with the newest block in the buffer 104, resulting in a convolved block 106 with a smear feature 106a resulting from the convolution operation.

The convolved block 106, 106a is then added 135 to a second buffer 107. The addition is performed in a similar way as described previously with reference to step 120: the block 106 is placed to be the first block in the buffer, summing samples of the block with any signal content from any earlier smear features in the same sample positions.

Next, the first complete block in the buffer 107 is upsampled 140 to form an upsampled block 108.

Figure 1 illustrates smearing features 108a on either side of the upsampled block 108. In this example of an embodiment, the upsampling is performed by inserting at least one sample with zero signal after or before each sample of the block to be upsampled, and low pass filtering the result. Depending on the filtering process, smearing features 108a may be created on one or both sides of the upsampled block 108.

The number of samples with zero signal inserted between samples of the block to be upsampled depends on the upsampling factor used in the particular implementation of an embodiment of the invention. If the upsampling factor is 2, one zero signal sample is inserted after or before each sample. If the upsampling factor is 4, three zero signal samples are inserted after or before each sample. If the upsampling factor is n, n-1 zero signal samples are inserted after or before each sample to make the size of the resulting upsampled block be n times the size of the block to be upsampled. In this embodiment, the upsampling factor is the same as the subsampling factor used in the subsampling step 115, resulting in the same block size as of the incoming signal block 101. A man skilled in the art knows many different ways to perform upsampling, whereby these are not described in further detail in this specification. The invention is not limited to use of any single specific method for performing upsampling.

Next, the upsampled block 108, 108a is added 145 to a third buffer 109. The addition is done in same way as previously described at steps 122 and 135: the block 108 is placed to be the first block in the buffer, summing samples of the block with any signal content from any earlier smear features in the same sample positions.

Next, the newest block in the buffer 109 is summed 150 with corresponding blocks of the other sub-bands to form the processed block 110.

The buffers 104, 107, 109 can be for example ring buffers or of an another type of endless buffer.

In an embodiment of the invention, a frequency sub-band is processed without subsampling. Processing of a sub-band block without subsampling has certain differences to the processing described previously with reference to figure 1. These differences are indicated with dashed arrows in figure 1. In this embodiment, the incoming signal block 101 is divided into more than one sub-band blocks 102 by filtering. The description in this paragraph describes the processing of one of these sub-band blocks 102. The sub-band block 102 with any smear features 102a is added 122b to a buffer 104. The addition is done in same way as previously described at steps 122, 135, and 145: the block 102 is placed to be the first block in the buffer, summing samples of the block with any signal content from any earlier smear features in the same sample positions. Next, a resonance analysis step is performed 125 on at least part of the content of the buffer 104, resulting in a filter response 105. The filter response is convolved 130 with the newest block in the buffer 104, resulting in a convolved block 106 with a smear feature 106a resulting from the convolution operation. The convolved block 106, 106a is then added 135 to a second buffer 107. The addition is performed in a similar way as described previously: the block 106 is placed to be the first block in the buffer, summing samples of the block with any signal content from any earlier smear features in the same sample positions. Next, the newest block in the buffer 107 is summed 150b with corresponding blocks of the other sub-bands to form the processed block 110.

As can be seen in figure 1, since a non-subsampled frequency band does not need the upsampling step 140, also the third buffer 109 is not needed for a non-subsampled frequency band, and the final sub-band block that is to be summed with those of other sub-bands can be obtained from the second buffer 107 which is the result buffer for such a non-subsampled frequency band.

In a further embodiment of the invention, the step of convolving 130 a block with the filter response 105 is performed with the subsampled block 103,103a in the case of a subsampled sub-band, or with the filtered sub-band block 102,102a in the case of a non-subsampled sub-band, instead of the newest block in the buffer 104. Such an embodiment is typically slightly more computationally intensive, but still a possible way to implement the invention.

In an embodiment of the invention, the sub-band with highest frequency is processed without subsampling.

As figure 1 describes processing of a single incoming signal block, the processing is repeated for each incoming signal block in order to form a continous output signal. The processing of figure 1 also describes processing of only one signal channel.

In a further embodiment of the invention, in processing of signals such as a stereo signal with highly correlated channels, some parts of the processing may be combined for more than one channel. For example, in an embodiment of the invention the filtered sub-bands of the two channels of a stereo signal are added together before the resonance analysis step whereby the computationally intensive resonance analysis step is performed only once, and the resulting filter response is used separately for filtering each of the two channels of the stereo signal.

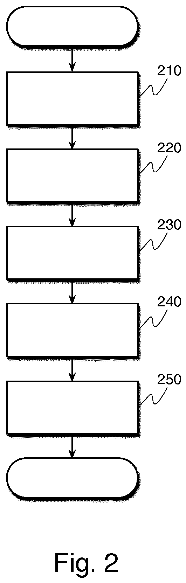

In the following, performing a resonance analysis step according to an embodiment of the invention is described in more detail with reference to figure 2. This resonance analysis step is performed on at least one block of sub-band signal data, and produces a filter response.

In step 210, a fast fourier transform is performed on at least one block of the sub-band signal data. The resulting complex response is transformed 220 into a real response. The real response can be for example a magnitude spectrum, a power spectrum, or another spectrum derived from one or both of these. The real response is overpass filtered 230 to remove any trends in the response and to retain only the peaks of the response.

A resonance response is calculated 240 on the basis of the filtered real response. The resonance response describes how much different frequencies of the spectrum are to be attenuated or not. This calculation can be performed for example using functions 1/(1+x) or -log(x). However, the invention is not limited to the use of only these particular functions. A man skilled in the art can form many other functions for calculation of a resonance response based on a spectrum of signal peaks which are to be attenuated.

Next, a filter response is formed 250 on the basis of the calculated resonance response. This can be performed for example using a Hilbert transform to obtain a minimum phase response. Various ways to determine a filter response that produces an attenuation or other change of the signal described by a resonance response is well known by a man skilled in the art, whereby these are not described in any further detail in this specification.

The resulting filter response is the filter response that is used in filtering in step 130 of figure 1.

Different embodiments of the invention provide some variations to the basic method described in figure 2. In an embodiment of the invention, the resonance analysis step comprises a step of windowing the sub-band signal data before the step of performing 210 a fast fourier transform in order to reduce spectral artifacts. Windowing, as a man skilled in the art knows, refers to multiplying the data by a predefined window function. In a further embodiment of the invention, the windowing function is weighted towards recent samples. However, the invention is not limited to any specific windowing function, and any windowing function known to a man skilled in the art may be used in different embodiments of the invention.

In various embodiments of the invention different processing steps are taken between the steps of highpass filtering 230 and calculation of a resonance response. As the filtered spectrum resulting from step 230 describes the peaks of the spectrum of the particular sub-band signal, and in step 240 a resonance response is calculated based on the spectrum to specify how to attenuate or otherwise change the signal at those peaks, any further processing of the spectrum between these two steps provides a versatile way to fine-tune the results of the resonance analysis process and the treatment of the audio signal. Various steps to process the spectrum between the steps 230 and 240 are described in the following. In various embodiments of the invention, any one of the following steps A to E may be taken, or more than one, in any order; or none of them.

Step A: Clipping the signal by removing spectrum content that is below a predetermined threshold, leaving only those peaks of the spectrum that are higher than the threshold. By controlling the threshold, one can adjust how high the spectral peaks need to be, before they affect signal processing in the resonance analysis phase.

Step B: Combining spectral information with the corresponding information of previous runs of the resonance analysis step. In an embodiment of the invention, each bin of the spectrum is averaged using a sliding average over a number of runs of the resonance analysis step. Such averaging would allow reacting to peaks that arise slowly, or slow down attenuation of peaks.

Step C: Dynamic remapping of bin values, i.e. by passing the bin value through a mathematical function in order to adjust the bin value. This can be used for example to reduce the spectrum peaks proportionally to their height so that higher peaks are reduced proportionally more than lower peaks. As a result, when the resonance response is calculated in step 240, the higher peaks are then attenuated proportionally less than lower peaks.

Step D: Rounding the peaks of the spectrum by lowpass filtering. This operation widens the peaks of the spectrum. This can reduce the amount of artefacts caused by the processing itself, as a wider spectral feature can be represented by a shorter filter and thus reduce ringing of the resulting filter in the time domain.

Step E: Weighting of certain frequencies. This operation can be used for example for simply weighting certain frequency ranges in the analysis, or for example to provide a better fit of the produced filter response of different sub-bands to each other.

The invention is not limited to the steps A to E in processing of the spectrum between the steps 230 and 240. Embodiments of the invention can process the spectrum using other signal processing steps known to a man skilled in the art.

The invention can be implemented in many different ways. The inventive method can be implemented in a dedicated signal processing device, as a part of a sound processing device such as a digital mixer unit, or for example as computer software stored on a computer readable medium.

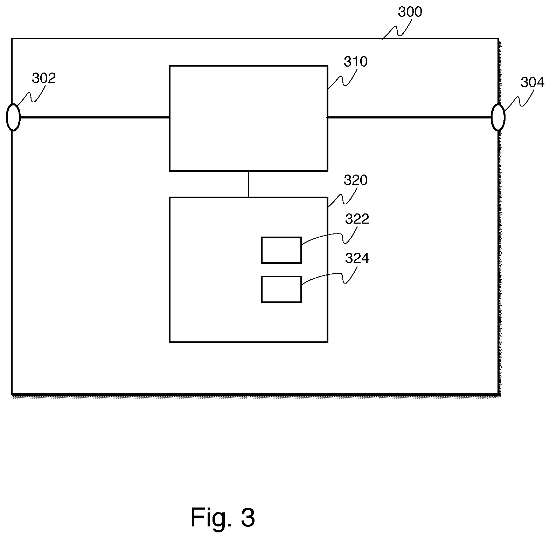

Figure 3 illustrates a sound processing device 300. The device can be for example a digital mixer unit or a dedicated sound processing device.

The device 300 comprises a processor 310 functionally connected to an input 302 and an output 304. The device comprises also a memory element 320 storing instructions 322, 324 to be executed by the processor. The instructions, when executed by the processor 310, cause the processor to perform the inventive method as described in this specification and defined in the claims.

In further embodiments of the invention the device 300 can also comprise other functional elements known to a man skilled in the art such as analog-to-digital (AD) and digital-to-analog (DA) converters. The device can also comprise a plurality of processors. The processors can be dedicated signal processing processors, generic programmable microprocessors or for example processors implemented using FPGAs (field programmable gate arrays).

The invention can also be implemented as a software product, as instructions stored on a storage media such that the instructions, when executed by a processor, cause the processor to perform the inventive method described in the claims. The storage media can be a semiconductor based device such as a volatile memory device, or for example a non-volatile flash memory device. Some further examples of such machine-readable storage media include RAM, ROM, read-only compact discs (CD-ROM), recordable compact discs (CD-R), rewritable compact discs (CD-RW), read-only digital versatile discs (e.g., DVD-ROM, dual-layer DVD-ROM), a variety of recordable/rewritable DVDs (e.g., DVD-RAM, DVD-RW, DVD+RW, etc.), flash memory (e.g., SD cards, mini-SD cards, micro-SD cards, etc.), magnetic and/or solid state hard drives, read-only and recordable Blu-Ray discs, ultra density optical discs, and any other optical or magnetic media.The invention can also be implemented as a downloadable softare product that can be installed in a sound processing device.

The invention has several benefits. The invention saves processing power, which reduces the cost of the signal processing chain. The invention allows more processing than prior art solutions while keeping within maximum allowable processing delays in the signal processing chain. The invention allows automatic processing and attenuation of resonances arising in the sound signal during a live event.

Saving of processing power allows processing of more signal channels with the same processor, or executing more signal processing instances on the same processor. Saving of processing power also allows for use of a cheaper processor, and savings in energy use. The inventive method also reduces the need for cache memory due to smaller vector sizes provided by the downsampling operation. The inventive method also provides lower latency, since the process can due to reduced processing power requirements be performed more often i.e. with smaller input block size. The invention also allows processing of low frequencies with smaller FFT sizes, which allows provision of better resolution at low frequencies.

## Claims

1. A method for attenuating resonances in a digital sound signal, wherein the method comprises at least the steps of receiving a first block (101) of new sound samples,
filtering (120) said first block into at least two sub-band signals (102, 102a) representing different frequency bands of the audio content in said first block, and performing at least the following steps S1 to S7 for at least a first sub-band signal of said at least two sub-band signals:
S1) sub-sampling (121) said sub-band signal,
S2) adding (122) the sub-sampled signal (103,103a) to a first buffer (104) for the corresponding frequency band,
S3) performing (125) a resonance analysis step for the first buffer for the corresponding frequency band, thereby producing a filter response (105) for the corresponding frequency band,
S4) convolving (130) the sub-sampled signal (103,103a) or the first complete block of the first buffer with the filter response (105) for the corresponding frequency band,
S5) adding (135) the convolution result to a second buffer (107) for the corresponding frequency band,
S6) upsampling (140) the first complete block of said second buffer for the corresponding frequency band, and
S7) adding (145) the upsampled result to a result buffer (109) for the corresponding frequency band; and
summing (150) the first complete blocks of said result buffers for each frequency band to form an output block,
said step of performing resonance analysis on the first buffer comprising at least the steps
of
performing (210) a fast fourier transform on a plurality of latest blocks of said first buffer,
converting (220) the resulting complex response into a real response,
highpass filtering (230) of said real response to retain only peaks of said real response,
forming (240) a resonance response based on said filtered real response, and
forming (250) said filter response (105) based on the resonance response.

2. A method according to claim 1, **characterized in that**
at least the following steps are performed for at least a second sub-band signal of said at least two sub-band signals:
adding (122b) the sub-band signal (102,102a) to a second buffer (104) for the
corresponding frequency band,
performing (125) a resonance analysis step for the second buffer for the corresponding
frequency band, thereby producing a second filter response (105) for the corresponding frequency band,
convolving (130) the sub-band signal (102,102a) or the first complete block of the second buffer with the second filter response for the corresponding frequency band, and
adding the convolution result (106, 106a) to a second result buffer for the corresponding
frequency band,
wherein said step of performing resonance analysis on the second buffer comprises at least the steps of:
performing (210) a fast Fourier transform on a plurality of latest blocks of said second buffer,
converting (220) the resulting complex response into a second real response,
highpass filtering (230) of said second real response to retain only peaks of said second real response,
forming (240) a second resonance response based on said second filtered real response, and
forming (250) said second filter response (105) based on the second resonance response.

3. A method according to claim 1, **characterized in that** the method further comprises at least the step of windowing the data in said first buffer before the step of performing (210) a fast fourier transform.

4. A method according to claim 1, **characterized in that** the method further comprises at least the step of clipping said filtered real response after the step of highpass filtering to remove any signal in said filtered real response that is lower than a predetermined threshold.

5. A sound processing device (300)
having one or more processors (310); and
one or more computer-readable storage media (320), wherein the storage media has instructions (322, 324) stored thereon that, when executed by the one or more processors, cause the one or more processors to perform at least the steps of receiving a first block (101) of new sound samples,
filtering (120) said first block into at least two sub-band signals (102, 102a) representing different frequency bands of the audio content in said first block, and performing at least the following steps S1 to S7 for at least a first sub-band signal of said at least two sub-band signals:
S1) sub-sampling (121) said sub-band signal,
S2) adding (122) the sub-sampled signal to a first buffer (104) for the corresponding frequency band,
S3) performing (125) a resonance analysis step for the first buffer for the corresponding frequency band, thereby producing a filter response (105) for the corresponding frequency band,
S4) convolving (130) the sub-sampled signal (103,103a) or the first complete block of the first buffer with the filter response (105) for the corresponding frequency band,
S5) adding (135) the convolution result to a second buffer (107) for the corresponding frequency band,
S6) upsampling (140) the first complete block of said second buffer for the corresponding frequency band, and
S7) adding (145) the upsampled result to a result buffer (109) for the corresponding frequency band; and
summing (150) the first complete blocks of said result buffers for each frequency band to form an output block,
the storage media (320) further having instructions stored thereon that, when executed by the one or more processors, cause the one or more processors to
perform in said step of performing resonance analysis on the first buffer at least the steps of
performing (210) a fast fourier transform on a plurality of latest blocks of said first buffer,
converting (220) the resulting complex response into a real response,
highpass filtering (230) of said real response to retain only peaks of said real response,
forming (240) a resonance response based on said filtered real response, and
forming (250) said filter response (105) based on the resonance response.

6. A sound processing device (300) according to claim 5,
**characterized in that** the storage media (320) further has instructions stored thereon that, when executed by the one or more processors (310), cause the one or more processors to perform at least the following steps for at least a second sub-band signal of said at least two sub-band signals:
adding (122b) the sub-band signal (102,102a) to a second buffer (104) for the
corresponding frequency band,
performing (125) a resonance analysis step for the second buffer for the corresponding
frequency band, thereby producing a second filter response (105) for the corresponding frequency band,
convolving (130) the sub-band signal (102,102a) or the first complete block of the second buffer with the second filter response for the corresponding frequency band, and
adding the convolution result (106, 106b) to a second result buffer for the corresponding
frequency band,
wherein said step of performing resonance analysis on the second buffer comprises at least the steps of:
performing (210) a fast Fourier transform on a plurality of latest blocks of said second buffer,
converting (220) the resulting complex response into a second real response,
highpass filtering (230) of said second real response to retain only peaks of said second real response,
forming (240) a second resonance response based on said second filtered real response, and
forming (250) said second filter response (105) based on the second resonance response.

7. Computer-readable storage media (320) wherein the storage media has instructions stored thereon that, when executed by a processor, cause the processor to perform at least the steps of receiving a first block (101) of new sound samples,
filtering (120) said first block into at least two sub-band signals (102, 102a) representing different frequency bands of the audio content in said first block, and performing at least the following steps S1 to S7 for at least a first sub-band signal of said at least two sub-band signals:
S1) sub-sampling (121) said sub-band signal,
S2) adding (122) the sub-sampled signal to a first buffer for the corresponding frequency band,
S3) performing (125) a resonance analysis step for the first buffer for the corresponding frequency band, thereby producing a filter response (105) for the corresponding frequency band,
S4) convolving (130) the sub-sampled signal (103,103a) or the first complete block of the first buffer with the filter response (105) for the corresponding frequency band,
S5) adding (135) the convolution result to a second buffer (107) for the corresponding frequency band,
S6) upsampling (140) the first complete block of said second buffer for the corresponding frequency band, and
S7) adding (145) the upsampled result to a result buffer for the corresponding frequency band; and
summing (150) the first complete blocks of said result buffers for each frequency band to form an output block;
the storage media further having instructions stored thereon that, when executed by a processor, cause the processor to perform in said step of performing resonance analysis on the first buffer at least the steps of
performing (210) a fast fourier transform on a plurality of latest blocks of said first buffer,
converting (220) the resulting complex response into a real response,
highpass filtering (230) of said real response to retain only peaks of said real response,
forming (240) a resonance response based on said filtered real response, and
forming (250) said filter response (105) based on the resonance response.

8. Computer-readable storage media (320) according to claim 7, **characterized in that**
the storage media further has instructions stored thereon that, when executed by a processor, cause the processor to perform a at least the following steps for at least a second sub-band signal of said at least two sub-band signals:
adding (122b) the sub-band signal (102,102a) to a second buffer for the corresponding
frequency band,
performing (125) a resonance analysis step for the second buffer for the corresponding
frequency band, thereby producing a second filter response for the corresponding frequency band,
convolving (130) the sub-band signal (102,102a) or the first complete block of the second buffer with the second filter response for the corresponding frequency band, and
adding the convolution result to a result buffer for the corresponding frequency band,
wherein said step of performing resonance analysis on the second buffer comprises at least the steps of:
performing (210) a fast Fourier transform on a plurality of latest blocks of said second buffer,
converting (220) the resulting complex response into a second real response,
highpass filtering (230) of said second real response to retain only peaks of said second real response,
forming (240) a second resonance response based on said second filtered real response, and
forming (250) said second filter response (105) based on the second resonance response.

## Patentansprüche

1. Verfahren zum Dämpfen von Resonanzen in einem digitalen Tonsignal, wobei das Verfahren mindestens die Schritte eines Empfangens eines ersten Blocks (101) neuer Tonproben umfasst,
Filtern (120) des ersten Blocks in mindestens zwei Teilbandsignale (102, 102a), die unterschiedliche Frequenzbänder des Audioinhalts in dem ersten Block darstellen, und Durchführen mindestens der folgenden Schritte S1 bis S7 für mindestens ein erstes Teilbandsignal der mindestens zwei Teilbandsignale:
S1) Unterabtasten (121) des Teilbandsignals,
S2) Hinzufügen (122) des unterabgetasteten Signals (103,103a) zu einem ersten Puffer (104) für das entsprechende Frequenzband,
S3) Durchführen (125) eines Resonanzanalyseschritts für den ersten Puffer für das entsprechende Frequenzband, wodurch eine Filterantwort (105) für das entsprechende Frequenzband produziert wird,
S4) Falten (130) des unterabgetasteten Signals (103,103a) oder des ersten vollständigen Blocks des ersten Puffers mit der Filterantwort (105) für das entsprechende Frequenzband,
S5) Hinzufügen (135) des Faltungsergebnisses zu einem zweiten Puffer (107) für das entsprechende Frequenzband,
S6) Aufwärtsabtasten (140) des ersten vollständigen Blocks des zweiten Puffers für das entsprechende Frequenzband, und
S7) Hinzufügen (145) des aufwärtsabgetasteten Ergebnisses zu einem Ergebnispuffer (109) für das entsprechende Frequenzband; und
Summieren (150) der ersten vollständigen Blöcke der Ergebnispuffer für jedes Frequenzband, um einen Ausgabeblock auszubilden,
der Schritt des Durchführens einer Resonanzanalyse auf dem ersten Puffer umfassend mindestens die Schritte
Durchführen (210) einer schnellen Fourier-Transformation an einer Vielzahl von neuesten Blöcken des ersten Puffers,
Umwandeln (220) der resultierenden komplexen Antwort in eine reelle Antwort,
Hochpassfiltern (230) der reellen Antwort, um nur Spitzen der reellen Antwort beizubehalten,
Ausbilden (240) einer Resonanzantwort basierend auf der gefilterten reellen Antwort, und
Ausbilden (250) der Filterantwort (105) basierend auf der Resonanzantwort.

2. . Verfahren nach Anspruch 1, **dadurch gekennzeichnet, dass**
mindestens die folgenden Schritte für mindestens ein zweites Teilbandsignal von den mindestens zwei Teilbandsignalen durchgeführt werden:
Hinzufügen (122b) des Teilbandsignals (102,102a) zu einem zweiten Puffer (104) für das entsprechende Frequenzband,
Durchführen (125) eines Resonanzanalyseschritts für den zweiten Puffer für das entsprechende Frequenzband, wodurch eine zweite Filterantwort (105) für das entsprechende Frequenzband produziert wird,
Falten (130) des Teilbandsignals (102,102a) oder des ersten vollständigen Blocks des zweiten Puffers mit der zweiten Filterantwort für das entsprechende Frequenzband, und
Hinzufügen des Faltungsergebnisses (106, 106a) zu einem zweiten Ergebnispuffer für das entsprechende Frequenzband,
wobei der Schritt des Durchführens der Resonanzanalyse an dem zweiten Puffer mindestens die Schritte umfasst:
Durchführen (210) einer schnellen Fourier-Transformation an einer Vielzahl von neuesten Blöcken des zweiten Puffers,
Umwandeln (220) der resultierenden komplexen Antwort in eine zweite reelle Antwort,
Hochpassfiltern (230) der zweiten reellen Antwort, um nur die Spitzen der zweiten reellen Antwort beizubehalten,
Ausbilden (240) einer zweiten Resonanzantwort basierend auf der zweiten gefilterten reellen Antwort, und
Ausbilden (250) der zweiten Filterantwort (105) basierend auf der zweiten Resonanzantwort.

3. . Verfahren nach Anspruch 1, **dadurch gekennzeichnet, dass**
das Verfahren ferner mindestens den Schritt umfasst
Windowing der Daten in dem ersten Puffer vor dem Schritt des Durchführens (210) einer schnellen Fourier-Transformation.

4. . Verfahren nach Anspruch 1, **dadurch gekennzeichnet, dass**
das Verfahren ferner mindestens den Schritt umfasst
Beschneiden der gefilterten reellen Antwort nach dem Schritt des Hochpassfilterns, um ein beliebiges Signal in der gefilterten reellen Antwort zu entfernen, das niedriger als ein vorbestimmter Schwellenwert ist.

5. . Tonverarbeitungsvorrichtung (300)
aufweisend einen oder mehrere Prozessoren (310); und
ein oder mehrere computerlesbare Speichermedien (320),
wobei das Speichermedium Anweisungen (322, 324) darauf gespeichert aufweist, die, wenn sie durch den einen oder die mehreren Prozessoren ausgeführt werden, den einen oder die mehreren Prozessoren veranlassen, mindestens die Schritte zu durchführen
Empfangen eines ersten Blocks (101) neuer Tonproben,
Filtern (120) des ersten Blocks in mindestens zwei Teilbandsignale (102, 102a), die unterschiedliche Frequenzbänder des Audioinhalts in dem ersten Block darstellen, und Durchführen mindestens der folgenden Schritte S1 bis S7 für mindestens ein erstes Teilbandsignal der mindestens zwei Teilbandsignale:
S1) Unterabtasten (121) des Teilbandsignals,
S2) Hinzufügen (122) des unterabgetasteten Signals zu einem ersten Puffer (104) für das entsprechende Frequenzband,
S3) Durchführen (125) eines Resonanzanalyseschritts für den ersten Puffer für das entsprechende Frequenzband, wodurch eine Filterantwort (105) für das entsprechende Frequenzband produziert wird,
S4) Falten (130) des unterabgetasteten Signals (103,103a) oder des ersten vollständigen Blocks des ersten Puffers mit der Filterantwort (105) für das entsprechende Frequenzband,
S5) Hinzufügen (135) des Faltungsergebnisses zu einem zweiten Puffer (107) für das entsprechende Frequenzband,
S6) Aufwärtsabtasten (140) des ersten vollständigen Blocks des zweiten Puffers für das entsprechende Frequenzband, und
S7) Hinzufügen (145) des aufwärtsabgetasteten Ergebnisses zu einem Ergebnispuffer (109) für das entsprechende Frequenzband; und
Summieren (150) der ersten vollständigen Blöcke der Ergebnispuffer für jedes Frequenzband, um einen Ausgabeblock auszubilden,
das Speichermedium (320) ferner darauf gespeicherte Anweisungen aufweist, die, wenn sie durch den einen oder die mehreren Prozessoren ausgeführt werden, den einen oder die mehreren Prozessoren veranlassen, in dem Schritt des Durchführens der Resonanzanalyse an dem ersten Puffer mindestens die Schritte durchzuführen
Durchführen (210) einer schnellen Fourier-Transformation an einer Vielzahl von neuesten Blöcken des ersten Puffers,
Umwandeln (220) der resultierenden komplexen Antwort in eine reelle Antwort,
Hochpassfiltern (230) der reellen Antwort, um nur Spitzen der reellen Antwort beizubehalten,
Ausbilden (240) einer Resonanzantwort basierend auf der gefilterten reellen Antwort, und
Ausbilden (250) der Filterantwort (105) basierend auf der Resonanzantwort.

6. . Tonverarbeitungsvorrichtung (300) nach Anspruch 5,
**dadurch gekennzeichnet, dass**
das Speichermedium (320) ferner Anweisungen darauf gespeichert aufweist, die, wenn sie durch den einen oder die mehreren Prozessoren (310) ausgeführt werden, den einen oder die mehreren Prozessoren veranlassen, mindestens die folgenden Schritte für mindestens ein zweites Teilbandsignal der mindestens zwei Teilbandsignale durchzuführen:
Hinzufügen (122b) des Teilbandsignals (102,102a) zu einem zweiten Puffer (104) für das entsprechende Frequenzband,
Durchführen (125) eines Resonanzanalyseschritts für den zweiten Puffer für das entsprechende Frequenzband, wodurch eine zweite Filterantwort (105) für das entsprechende Frequenzband produziert wird,
Falten (130) des Teilbandsignals (102,102a) oder des ersten vollständigen Blocks des zweiten Puffers mit der zweiten Filterantwort für das entsprechende Frequenzband, und
Hinzufügen des Faltungsergebnisses (106, 106b) zu einem zweiten Ergebnispuffer für das entsprechende Frequenzband,
wobei der Schritt des Durchführens der Resonanzanalyse an dem zweiten Puffer mindestens die Schritte umfasst:
Durchführen (210) einer schnellen Fourier-Transformation an einer Vielzahl von neuesten Blöcken des zweiten Puffers,
Umwandeln (220) der resultierenden komplexen Antwort in eine zweite reelle Antwort,
Hochpassfiltern (230) der zweiten reellen Antwort, um nur die Spitzen der zweiten reellen Antwort beizubehalten,
Ausbilden (240) einer zweiten Resonanzantwort basierend auf der zweiten gefilterten reellen Antwort, und
Ausbilden (250) der zweiten Filterantwort (105) basierend auf der zweiten Resonanzantwort.

7. . Computerlesbare Speichermedien (320)
wobei das Speichermedium Anweisungen darauf gespeichert aufweist, die, wenn sie durch einen Prozessor ausgeführt werden, den Prozessor veranlassen, mindestens die Schritte durchzuführen
Empfangen eines ersten Blocks (101) neuer Tonproben,
Filtern (120) des ersten Blocks in mindestens zwei Teilbandsignale (102, 102a), die unterschiedliche Frequenzbänder des Audioinhalts in dem ersten Block darstellen, und
Durchführen mindestens der folgenden Schritte S1 bis S7 für mindestens ein erstes Teilbandsignal von den mindestens zwei Teilbandsignalen:
S1) Unterabtasten (121) des Teilbandsignals,
S2) Hinzufügen (122) des unterabgetasteten Signals zu einem ersten Puffer für das entsprechende Frequenzband,
S3) Durchführen (125) eines Resonanzanalyseschritts für den ersten Puffer für das entsprechende Frequenzband, wodurch eine Filterantwort (105) für das entsprechende Frequenzband produziert wird,
S4) Falten (130) des unterabgetasteten Signals (103,103a) oder des ersten vollständigen Blocks des ersten Puffers mit der Filterantwort (105) für das entsprechende Frequenzband,
S5) Hinzufügen (135) des Faltungsergebnisses zu einem zweiten Puffer (107) für das entsprechende Frequenzband,
S6) Aufwärtsabtasten (140) des ersten vollständigen Blocks des zweiten Puffers für das entsprechende Frequenzband, und
S7) Hinzufügen (145) des aufwärtsabgetasteten Ergebnisses zu einem Ergebnispuffer für das entsprechende Frequenzband; und
Summieren (150) der ersten vollständigen Blöcke der Ergebnispuffer für jedes Frequenzband, um einen Ausgabeblock auszubilden;
das Speichermedium ferner Anweisungen darauf gespeichert aufweist, die, wenn sie durch einen Prozessor ausgeführt werden, den Prozessor veranlassen, in dem Schritt des Durchführens der Resonanzanalyse an dem ersten Puffer mindestens die Schritte durchzuführen
Durchführen (210) einer schnellen Fourier-Transformation an einer Vielzahl von neuesten Blöcken des ersten Puffers,
Umwandeln (220) der resultierenden komplexen Antwort in eine reelle Antwort,
Hochpassfiltern (230) der reellen Antwort, um nur Spitzen der reellen Antwort beizubehalten,
Ausbilden (240) einer Resonanzantwort basierend auf der gefilterten reellen Antwort, und
Ausbilden (250) der Filterantwort (105) basierend auf der Resonanzantwort.

8. . Computerlesbare Speichermedien (320) nach Anspruch 7,
**dadurch gekennzeichnet, dass**
das Speichermedium ferner Anweisungen darauf gespeichert aufweist, die, wenn sie durch einen Prozessor ausgeführt werden, den Prozessor veranlassen, mindestens die folgenden Schritte für mindestens ein zweites Teilbandsignal von den mindestens zwei Teilbandsignalen durchzuführen:
Hinzufügen (122b) des Teilbandsignals (102,102a) zu einem zweiten Puffer für das entsprechende Frequenzband,
Durchführen (125) eines Resonanzanalyseschritts für den zweiten Puffer für das entsprechende Frequenzband, wodurch eine zweite Filterantwort für das entsprechende Frequenzband produziert wird,
Falten (130) des Teilbandsignals (102,102a) oder des ersten vollständigen Blocks des zweiten Puffers mit der zweiten Filterantwort für das entsprechende Frequenzband, und
Hinzufügen des Faltungsergebnisses zu einem Ergebnispuffer für das entsprechende Frequenzband,
wobei der Schritt des Durchführens der Resonanzanalyse an dem zweiten Puffer mindestens die Schritte umfasst:
Durchführen (210) einer schnellen Fourier-Transformation an einer Vielzahl von neuesten Blöcken des zweiten Puffers,
Umwandeln (220) der resultierenden komplexen Antwort in eine zweite reelle Antwort,
Hochpassfiltern (230) der zweiten reellen Antwort, um nur die Spitzen der zweiten reellen Antwort beizubehalten,
Ausbilden (240) einer zweiten Resonanzantwort basierend auf der zweiten gefilterten reellen Antwort, und
Ausbilden (250) der zweiten Filterantwort (105) basierend auf der zweiten Resonanzantwort.

## Revendications

1. Procédé d'atténuation de résonances dans un signal sonore numérique, dans lequel le procédé comprend au moins les étapes consistant à recevoir un premier bloc (101) de nouveaux échantillons sonores,
le filtrage (120) dudit premier bloc en au moins deux signaux de sous-bande (102, 102a) représentant différentes bandes de fréquences du contenu audio dans ledit premier bloc, et la réalisation d'au moins les étapes suivantes S1 à S7 pour au moins un premier signal de sous-bande desdits au moins deux signaux de sous-bande :
S1) le sous-échantillonnage (121) dudit signal de sous-bande,
S2) l'ajout (122) du signal sous-échantillonné (103, 103a) dans un premier tampon (104) pour la bande de fréquence correspondante,
S3) la réalisation (125) d'une étape pour analyse de résonance pour le premier tampon pour la bande de fréquence correspondante, produisant ainsi une réponse de filtre (105) pour la bande de fréquence correspondante,
S4) la convolution (130) du signal sous-échantillonné (103, 103a) ou du premier bloc complet du premier tampon avec la réponse de filtre (105) pour la bande de fréquence correspondante,
S5) l'ajout (135) du résultat de convolution à un second tampon (107) pour la bande de fréquence correspondante,
S6) le suréchantillonnage (140) du premier bloc complet dudit second tampon pour la bande de fréquence correspondante, et
S7) l'ajout (145) du résultat suréchantillonné à un tampon de résultats (109) pour la bande de fréquence correspondante ; et
la sommation (150) des premiers blocs complets desdits tampons de résultats pour chaque bande de fréquence afin de former un bloc de sortie,
ladite étape de réalisation d'une analyse de résonance sur le premier tampon comprenant au moins les étapes consistant à
la réalisation (210) d'une transformée de Fourier rapide sur une pluralité de blocs les plus récents dudit premier tampon,
la conversion (220) de la réponse complexe résultante en une réponse réelle,
un filtrage passe-haut (230) de ladite réponse réelle pour ne conserver que des pics de ladite réponse réelle,
la formation (240) d'une réponse de résonance en fonction de ladite réponse réelle filtrée, et
la formation (250) de ladite réponse de filtre (105) en fonction de la réponse de résonance.

2. . Procédé selon la revendication 1, **caractérisé en ce que**
au moins les étapes suivantes sont réalisées pour au moins un second signal de sous-bande desdits au moins deux signaux de sous-bande :
l'ajout (122b) du signal de sous-bande (102, 102a) à un second tampon (104) pour la bande de fréquence correspondante,
la réalisation (125) d'une étape pour analyse de résonance pour le second tampon pour la bande de fréquence correspondante, produisant ainsi une seconde réponse de filtre (105) pour la bande de fréquence correspondante,
la convolution (130) du signal de sous-bande (102, 102a) ou du premier bloc complet du second tampon avec la seconde réponse de filtre pour la bande de fréquence correspondante, et
l'ajout du résultat de convolution (106, 106A) dans un second tampon de résultats pour la bande de fréquence correspondante,
dans lequel ladite étape de réalisation d'une analyse de résonance sur le second tampon comprend au moins les étapes consistant à :
la réalisation (210) d'une transformée de Fourier rapide sur une pluralité des derniers blocs dudit second tampon,
la conversion (220) de la réponse complexe résultante en une seconde réponse réelle,
un filtrage passe-haut (230) de ladite seconde réponse réelle pour ne retenir que des pics de ladite seconde réponse réelle,
la formation (240) d'une seconde réponse de résonance en fonction de ladite seconde réponse réelle filtrée, et
la formation (250) de ladite seconde réponse de filtre (105) en fonction de la seconde réponse de résonance.

3. . Procédé selon la revendication 1, **caractérisé en ce que**
le procédé comprend en outre au moins l'étape consistant à
le fenêtrage des données dans ledit premier tampon avant l'étape consistant à effectuer (210) une transformée de Fourier rapide.

4. . Procédé selon la revendication 1, **caractérisé en ce que**
le procédé comprend en outre au moins l'étape consistant à
l'écrêtage de ladite réponse réelle filtrée après l'étape de filtrage passe-haut pour supprimer tout signal dans ladite réponse réelle filtrée qui est inférieur à un seuil prédéterminé.

5. . Dispositif de traitement du son (300)
ayant un ou des processeurs (310) ; et
un ou des supports de stockage lisibles par un ordinateur (320),
dans lequel le support de stockage contient des instructions (322, 324) qui, lorsqu'elles sont exécutées par le ou les processeurs, amènent le ou les processeurs à mettre en œuvre au moins les étapes consistant à
la réception d'un premier bloc (101) de nouveaux échantillons sonores,
le filtrage (120) dudit premier bloc en au moins deux signaux de sous-bande (102, 102a) représentant différentes bandes de fréquences du contenu audio dans ledit premier bloc, et la réalisation d'au moins les étapes suivantes S1 à S7 pour au moins un premier signal de sous-bande desdits au moins deux signaux de sous-bande :
S1) le sous-échantillonnage (121) dudit signal de sous-bande,
S2) l'ajout (122) du signal sous-échantillonné dans un premier tampon (104) pour la bande de fréquence correspondante,
S3) la réalisation (125) d'une étape pour analyse de résonance pour le premier tampon pour la bande de fréquence correspondante, produisant ainsi une réponse de filtre (105) pour la bande de fréquence correspondante,
S4) la convolution (130) du signal sous-échantillonné (103, 103a) ou du premier bloc complet du premier tampon avec la réponse de filtre (105) pour la bande de fréquence correspondante,
S5) l'ajout (135) du résultat de convolution à un second tampon (107) pour la bande de fréquence correspondante,
S6) le suréchantillonnage (140) du premier bloc complet dudit second tampon pour la bande de fréquence correspondante, et
S7) l'ajout (145) du résultat suréchantillonné à un tampon de résultats (109) pour la bande de fréquence correspondante ; et
la sommation (150) des premiers blocs complets desdits tampons de résultats pour chaque bande de fréquence afin de former un bloc de sortie,
le support de stockage (320) ayant en outre des instructions stockées sur celui-ci qui, lorsqu'elles sont exécutées par le ou les processeurs, amènent le ou les processeurs à réaliser, dans ladite étape de réalisation d'une analyse de résonance sur le premier tampon, au moins les étapes consistant à
la réalisation (210) d'une transformée de Fourier rapide sur une pluralité de blocs les plus récents dudit premier tampon,
la conversion (220) de la réponse complexe résultante en une réponse réelle,
un filtrage passe-haut (230) de ladite réponse réelle pour ne conserver que des pics de ladite réponse réelle,
la formation (240) d'une réponse de résonance en fonction de ladite réponse réelle filtrée, et
la formation (250) de ladite réponse de filtre (105) en fonction de la réponse de résonance.

6. . Dispositif de traitement du son (300) selon la revendication 5,
**caractérisé en ce que**
le support de stockage (320) contient en outre des instructions stockées sur celui-ci qui, lorsqu'elles sont exécutées par le ou les processeurs (310), amènent le ou les processeurs à effectuer au moins les étapes suivantes pour au moins un second signal de sous-bande desdits au moins deux signaux de sous-bande :
l'ajout (122b) du signal de sous-bande (102, 102a) à un second tampon (104) pour la bande de fréquence correspondante,
la réalisation (125) d'une étape pour analyse de résonance pour le second tampon pour la bande de fréquence correspondante, produisant ainsi une seconde réponse de filtre (105) pour la bande de fréquence correspondante,
la convolution (130) du signal de sous-bande (102, 102a) ou du premier bloc complet du second tampon avec la seconde réponse de filtre pour la bande de fréquence correspondante, et
l'ajout du résultat de convolution (106, 106b) à un second tampon de résultats pour la bande de fréquence correspondante,
dans lequel ladite étape de réalisation d'une analyse de résonance sur le second tampon comprend au moins les étapes consistant à :
la réalisation (210) d'une transformée de Fourier rapide sur une pluralité des derniers blocs dudit second tampon,
la conversion (220) de la réponse complexe résultante en une seconde réponse réelle,
un filtrage passe-haut (230) de ladite seconde réponse réelle pour ne retenir que des pics de ladite seconde réponse réelle,
la formation (240) d'une seconde réponse de résonance en fonction de ladite seconde réponse réelle filtrée, et
la formation (250) de ladite seconde réponse de filtre (105) en fonction de la seconde réponse de résonance.

7. . Support de stockage lisible par ordinateur (320)
dans lequel le support de stockage contient des instructions stockées sur celui-ci qui, lorsqu'elles sont exécutées par un processeur, amènent le processeur à réaliser au moins les étapes consistant à
la réception d'un premier bloc (101) de nouveaux échantillons sonores,
le filtrage (120) dudit premier bloc en au moins deux signaux de sous-bande (102, 102a) représentant des bandes de fréquences différentes du contenu audio dans ledit premier bloc, et
la réalisation d'au moins les étapes suivantes S1 à S7 pour au moins un premier signal de sous-bande desdits au moins deux signaux de sous-bande :
S1) le sous-échantillonnage (121) dudit signal de sous-bande,
S2) l'ajout (122) du signal sous-échantillonné à un premier tampon pour la bande de fréquence correspondante,
S3) la réalisation (125) d'une étape pour analyse de résonance pour le premier tampon pour la bande de fréquence correspondante, produisant ainsi une réponse de filtre (105) pour la bande de fréquence correspondante,
S4) la convolution (130) du signal sous-échantillonné (103, 103a) ou du premier bloc complet du premier tampon avec la réponse de filtre (105) pour la bande de fréquence correspondante,
S5) l'ajout (135) du résultat de convolution à un second tampon (107) pour la bande de fréquence correspondante,
S6) le suréchantillonnage (140) du premier bloc complet dudit second tampon pour la bande de fréquence correspondante, et
S7) l'ajout (145) du résultat suréchantillonné à un tampon de résultats pour la bande de fréquence correspondante ; et
l'addition (150) des premiers blocs complets desdits tampons de résultats pour chaque bande de fréquence afin de former un bloc de sortie ;
le support de stockage contenant en outre des instructions stockées sur celui-ci qui, lorsqu'elles sont exécutées par un processeur, amènent le processeur à réaliser, dans ladite étape de réalisation d'analyse de résonance sur le premier tampon, au moins les étapes consistant à
la réalisation (210) d'une transformée de Fourier rapide sur une pluralité de blocs les plus récents dudit premier tampon,
la conversion (220) de la réponse complexe résultante en une réponse réelle,
un filtrage passe-haut (230) de ladite réponse réelle pour ne conserver que des pics de ladite réponse réelle,
la formation (240) d'une réponse de résonance en fonction de ladite réponse réelle filtrée, et
la formation (250) de ladite réponse de filtre (105) en fonction de la réponse de résonance.

8. . Support de stockage lisible par ordinateur (320) selon la revendication 7,
**caractérisé en ce que**
le support de stockage contient en outre des instructions stockées sur celui-ci qui, lorsqu'elles sont exécutées par un processeur, amènent le processeur à effectuer au moins les étapes suivantes pour au moins un second signal de sous-bande desdits au moins deux signaux de sous-bande :
l'ajout (122b) du signal de sous-bande (102, 102a) à un second tampon pour la bande de fréquence correspondante,
la réalisation (125) d'une étape pour analyse de résonance pour le second tampon pour la
bande de fréquence correspondante, produisant ainsi une seconde réponse de filtre pour la bande de fréquence correspondante,
la convolution (130) du signal de sous-bande (102, 102a) ou du premier bloc complet du second tampon avec la seconde réponse de filtre pour la bande de fréquence correspondante, et
l'ajout du résultat de convolution à un tampon de résultats pour la bande de fréquence correspondante,
dans lequel ladite étape de réalisation d'une analyse de résonance sur le second tampon comprend au moins les étapes consistant à :
la réalisation (210) d'une transformée de Fourier rapide sur une pluralité des derniers blocs dudit second tampon,
la conversion (220) de la réponse complexe résultante en une seconde réponse réelle,
un filtrage passe-haut (230) de ladite seconde réponse réelle pour ne retenir que des pics de ladite seconde réponse réelle,
la formation (240) d'une seconde réponse de résonance en fonction de ladite seconde réponse réelle filtrée, et
la formation (250) de ladite seconde réponse de filtre (105) en fonction de la seconde réponse de résonance.
